# EUROPEAN PATENT APPLICATION

(11) **EP 4 757 574 A1**
(43) Date of publication of application: **10.06.2026**
(21) Application number: 25210785.9
(22) Date of filing: 23.10.2025
(51) Int. Cl.: H10W 70/66, H10W 70/685, H10W 70/692, H10W 70/695

(54) **PACKAGING SUBSTRATE**

(30) Priority: 31.10.2024 US 202463714152 P
(71) Applicant: Absolics Inc., Covington, GA 30014 (US)
(72) Inventor: KIM, Sungjin, Covington, Georgia, 30014 (US); KIM, Jincheol, 18469 Hwaseong-si, Gyeonggi-do (KR)
(74) Representative: BCKIP Part mbB

(57) **Abstract**

A packaging substrate comprising a glass core, an upper redistribution layer, and a lower redistribution layer is provided. The glass core is a plate-shaped glass in which vias are arranged, the upper redistribution layer is disposed above the glass core, and the lower redistribution layer is disposed below the glass core. The redistribution layer comprises a wiring layer being a patterned copper layer having grains. C is an area ratio of grains having a major axis to minor axis ratio of 3:1 or greater in the wiring layer disposed in the upper redistribution layer, and D is an area ratio of grains having a major axis to minor axis ratio of 3:1 or greater in the wiring layer disposed in the lower redistribution layer. A value obtained by dividing C by D in the packaging substrate is 0.85 or more and 0.99 or less.

## Description

This application claims the priority of U.S. Provisional Patent Application No. 63/714,152, filed October 31, 2024.

### BACKGROUND

### Technical Field

The present embodiment relates to a packaging substrate in which the integrity and reliability of electrical signal transmission are improved.

### Description of Related Art

In the manufacture of electronic components, implementing circuits on a semiconductor wafer is referred to as the front-end (FE) process, and assembling the wafer into a state in which it can be used in actual products is referred to as the back-end (BE) process, with the packaging process being included in the back-end process.

Recently, four core technologies have enabled the rapid advancement of electronic products: semiconductor technology, semiconductor packaging technology, manufacturing process technology, and software technology. Semiconductor technology has evolved into various forms, such as sub-micron and nanometer-scale line widths, more than ten million cells, high-speed operation, and significant heat generation. However, the technology to perfectly package these semiconductors has not developed to the same extent. Consequently, the electrical performance of semiconductors may be determined not by the semiconductor technology itself, but by the packaging technology and the associated electrical connections.

Materials used for packaging substrates include ceramics or resins. In the case of ceramic substrates, high resistance values or high dielectric constants make it difficult to mount high-performance, high-frequency semiconductor elements. In the case of resin substrates, high-performance, high-frequency semiconductor elements can be mounted comparatively easily, but there are limitations in reducing the wiring pitch.

Recently, studies have been conducted on the application of glass substrates for high-end packaging substrates. By forming through-holes in a glass substrate and applying a conductive material to these through-holes, the wiring length between the device and the motherboard can be shortened, thereby achieving excellent electrical characteristics.

Related prior art includes Korean Patent No. 10-2400616 and Korean Patent Publication No. 10-2023-0154459.

### SUMMARY

In some embodiments, a packaging substrate that reduces signal reflection and distortion caused by impedance mismatch between wiring layers, thereby improving the quality of signal transmission is provided.

In some embodiments, a packaging substrate in which the crystalline structure of copper disposed in wiring layers is controlled to improve signal integrity and reduce issues such as electromagnetic interference during high-frequency signal transmission is provided.

In some embodiments, a packaging substrate that reduces heat generation during electrical signal transmission, thereby improving the efficiency of power delivery and signal transmission, and enhancing reliability is provided.

According to an embodiment, a packaging substrate comprises: a glass core; an upper redistribution layer; and a lower redistribution layer, wherein the glass core is a plate-shaped glass in which vias are disposed, the upper redistribution layer is disposed on an upper side of the glass core, the lower redistribution layer is disposed on a lower side of the glass core, and each of the upper and lower redistribution layers comprises a wiring layer and an insulating layer.

The wiring layer is a patterned copper layer having grains, and the insulating layer is a layer comprising an insulating polymer resin or an insulating inorganic material. An upper surface is located at an upper side of the upper redistribution layer, and an electronic device is mounted on the upper surface; a lower surface, facing the upper surface, is located at a lower side of the lower redistribution layer.

C represents the area ratio of grains having a long-axis-to-short-axis ratio of 3:1 or greater in the wiring layer disposed in the upper redistribution layer.

D represents the area ratio of grains having a long-axis-to-short-axis ratio of 3:1 or greater in the wiring layer disposed in the lower redistribution layer.

A value obtained by dividing C by D may be 0.85 or greater and 0.99 or less.

The copper layer comprises (111)-oriented grains, (200)-oriented grains, (220)-oriented grains, (211)-oriented grains, and (310)-oriented grains.

TC is a value obtained by summing the area ratios of the (220)-oriented grains, (211)-oriented grains, and (310)-oriented grains.

TD is a value obtained by summing the area ratios of the (111)-oriented grains and (200)-oriented grains.

A represents a ratio of TD to TC in the wiring layer disposed in the upper redistribution layer.

A value obtained by dividing A by B may be 0.60 or greater and 0.75 or less.

The average grain size in the wiring layer disposed in the lower redistribution layer may be greater than the average grain size in the wiring layer disposed in the upper redistribution layer.

A of the packaging substrate may be 0.2 or greater.

The average grain size in the wiring layer disposed in the upper redistribution layer may be 0.45 µm or greater and 0.48 µm or less.

The average grain size in the wiring layer disposed in the lower redistribution layer may be 0.50 µm or greater and 0.53 µm or less.

The packaging substrate may have an impedance 49 Ω or greater and 52 Ω or less.

The packaging substrate may have an electrical conductivity of 5.0 × 10⁷ S/m or greater.

The packaging substrate may have a reflection coefficient of 3.2% or less.

The packaging substrate may have a signal delay of 80 ps or less.

### BRIEF DESCRIPTION OF THE DRAWINGS

FIG. 1A is a view showing the EBSD map of Example 1-1;
FIG. 1B is a view showing the area ratio of grains having a long-axis-to-short-axis ratio of 3:1 in Example 1-1;
FIG. 1C is a view showing the area ratio of each oriented grain in Example 1-1;
FIG. 2A is a view showing the EBSD map of Example 1-2;
FIG. 2B is a view showing the area ratio of grains having a long-axis-to-short-axis ratio of 3:1 in Example 1-2; and
FIG. 2C is a view showing the area ratio of each oriented grain in Example 1-2.

### DESCRIPTION OF THE EMBODIMENTS

Hereinafter, embodiments will be described in detail with reference to the accompanying drawings so that those skilled in the art to which the present invention pertains may readily carry out the invention. However, the present invention may be embodied in various different forms and is not limited to the embodiments described herein. Throughout the specification, the same reference numerals are assigned to like parts.

In the present specification, the term "combinations thereof" included in a Markush-type expression refers to a mixture or combination of one or more components selected from the group consisting of the components described in the Markush-type expression, and means including one or more components selected from the group.

In the present specification, terms such as "first," "second," "A," and "B" are used to distinguish identical terms from each other. Singular expressions include plural forms unless the context clearly indicates otherwise.

In the present specification, "~ based" may mean including a compound corresponding to "~" or a derivative of "~" in the compound.

In the present specification, the expression "B is disposed on A" means that B is disposed directly on A or that B is disposed on A with another layer interposed therebetween, and is not to be construed as being limited to B being in direct contact with the surface of A.

In the present specification, the expression "B is connected to A" means that A and B are directly connected or connected through another component interposed therebetween, and unless otherwise specified, it is not to be construed as being limited to A and B being directly connected.

In the present specification, unless otherwise specified, a singular form is to be construed to include both singular and plural meanings depending on the context.

In the present specification, shapes, relative sizes, and angles of the respective components in the drawings may be exaggerated for the purpose of description, and the scope of rights is not to be construed as being limited to the drawings.

In the present specification, the expression "A and B are adjacent" means that A and B are positioned in contact with each other or close to each other without being in contact, and unless otherwise specified, it is not to be construed as being limited to A and B being in contact.

In the present specification, unless otherwise specified, the physical property values of each component in the packaging substrate are to be construed as being measured at room temperature, which is 20°C to 25°C.

In the embodiment, the packaging substrate applies a glass core, which has advantages distinguishing it from conventional silicon substrates and prepregs (polymer-impregnated glass fiber substrates). First, compared with prepregs, fine wiring patterns can be formed. In addition, a glass substrate has insulating properties, and thus the occurrence of parasitic elements is less likely even during high-frequency operation. This is in contrast to silicon substrates, which have semiconductor properties and therefore exhibit parasitic element phenomena during high-frequency operation.

For these reasons, a packaging substrate applying a glass core is advantageous for packaging semiconductor devices operating at high frequencies. However, with respect to electrical signal transmission, signal reflection or distortion may occur. Accordingly, the present embodiment recognizes the need to improve signal integrity and reliability in a packaging substrate, and proposes the embodiments described below.

Hereinafter, embodiments will be described in greater detail.

To achieve the above object, in one embodiment, the packaging substrate comprises a glass core, an upper redistribution layer, and a lower redistribution layer.

The glass core is a plate-shaped glass in which vias are formed.

The glass core is formed of a glass substrate for semiconductor use, which has a high commercial utility because it is less expensive and comparatively easier to manufacture in large areas than a sapphire substrate. Further, compared to semiconductor inorganic substrates such as silicon, it has the properties of an insulator, thereby providing advantages in that a packaging substrate applying the glass core exhibits higher power efficiency and stability at higher frequencies.

As the plate-shaped glass, a semiconductor glass substrate may be applied, and for example, borosilicate glass may be used, but the invention is not limited thereto.

The glass core is formed by forming vias in the plate-shaped glass, and other structures such as cavities may additionally be formed.

The glass core may be obtained by selectively etching or etching at different rates the plate-shaped glass. The etching may be laser etching or chemical etching. Selective etching of only the portions requiring etching may be performed using masking, or defects may be generated in the plate-shaped glass by laser or the like, and then the glass may be etched at different rates to manufacture a glass core having vias or the like.

An electrically conductive layer may be disposed on the surface of the glass core. For example, the electrically conductive layer may be a copper layer, but is not limited thereto.

The surface of the glass core comprises the upper surface and/or lower surface of the plate-shaped glass, and also comprises the surface of the vias.

The electrically conductive layer may be disposed on the upper surface and/or lower surface of the plate-shaped glass, or may be disposed to cover the surface of the vias or to fill the vias.

The packaging substrate may transmit electrical signals to devices or other substrates disposed on the upper and/or lower side of the glass core, using the glass core as a support.

The upper redistribution layer is a redistribution layer disposed on the upper side of the glass core.

An upper surface is located at an upper side of the upper redistribution layer, and an electronic device is mounted on the upper surface.

The lower redistribution layer is a redistribution layer disposed on the lower side of the glass core.

A lower surface is located at a lower side of the lower redistribution layer, facing the upper surface.

A redistribution layer comprises a wiring layer and an insulating layer.

The wiring layer is a patterned copper layer.

The copper layer comprises metallic copper having grains.

The copper layer may be an electroplated layer.

The insulating layer is a layer comprising an insulating polymer resin or an insulating inorganic material.

The insulating polymer resin may be, for example, an epoxy resin or a polyimide resin. The insulating inorganic material may be, for example, silica.

For example, the insulating layer may be an ABF (Ajinomoto Build-up Film), an EMC (Epoxy Molding Compound).

The wiring layer may be arranged in a predetermined pattern.

A circuit layer refers to a copper layer arranged in a predetermined planar pattern.

A through-electrode refers to a pattern in which copper layers are connected vertically.

The wiring layer may comprise both the circuit layer and the through-electrode.

One layer of the wiring layer collectively refers to one layer of the through-electrode and one layer of the circuit layer connected thereto.

The upper redistribution layer may comprise one or more, two or more, or three or more wiring layers, and may comprise 25 or fewer, 20 or fewer, or 15 or fewer wiring layers.

The lower redistribution layer may comprise one or more, two or more, or three or more wiring layers, and may comprise 20 or fewer, 15 or fewer, or 10 or fewer wiring layers.

The packaging substrate may further comprise a cover layer on the upper redistribution layer. The cover layer may be a polyimide layer, but is not limited thereto.

The packaging substrate may further comprise a solder resist layer beneath the lower redistribution layer. The solder resist layer may be a solder resist or a solder mask composition applied in semiconductors.

The wiring layer plays an important role in the electrical signal transmission of a packaging substrate. For example, when impedance mismatch occurs between the upper wiring layer and the lower wiring layer of the packaging substrate, signal reflection and distortion may frequently occur. In particular, such impedance mismatch existing in high-speed signal transmission paths of a semiconductor substrate degrades signal quality and reduces the reliability of data transmission. Consequently, when impedance mismatch occurs between the upper and lower wiring layers of the packaging substrate, there is a limitation in maintaining signal integrity in modern electronic devices requiring high-speed communication.

In addition, the balance of the crystalline structure between wiring layers is also related to signal integrity. Specifically, a difference in grain structure may occur between the upper wiring layer and the lower wiring layer of the packaging substrate, and such difference may cause non-uniformity in electron migration paths. This is one of the causes of problems such as electromagnetic interference (EMI) during high-frequency signal transmission. Further, such imbalance in crystalline structure may cause distortion during signal transmission, leading to degradation of system performance. Moreover, a significant difference in electrical conductivity between the upper and lower wiring layers may result in reduced efficiency of power delivery and signal transmission.

Accordingly, the inventors have confirmed that alleviating conductivity differences, improving impedance matching, reducing signal loss in transmission paths, and mitigating heat generation between the upper and lower wiring layers of a packaging substrate can ultimately have a positive effect on the overall reliability and service life of the packaging substrate and a semiconductor package to which it is applied, and have thus proposed the present embodiment.

(111), (200), (220), (211), and (310) each represent a crystallographic orientation of copper grains. The copper layer comprises (111)-oriented grains, (200)-oriented grains, (220)-oriented grains, (211)-oriented grains, and (310)-oriented grains.

The orientation distribution, ratio, and other characteristics of copper grains in the wiring layer can be determined through EBSD (Electron Backscatter Diffraction) measurement. The specific measurement methods and conditions are as described in the experimental examples.

The (111) plane is the most densely packed atomic plane in a face-centered cubic (FCC) structure. This plane exhibits high electrical conductivity and excellent mechanical strength.

The (200) plane is equivalent to the (100) plane and has the second-highest atomic packing density, also exhibiting relatively good electrical conductivity.

The (220) plane is equivalent to the (110) plane and has a medium atomic density.

The (211) and (310) planes have relatively lower atomic packing densities.

TC is the sum of the area ratios of the (220)-oriented grains, (211)-oriented grains, and (310)-oriented grains.

TD is the sum of the area ratios of the (111)-oriented grains and (200)-oriented grains.

The ratio of TC to TD is related to the distribution ratio between grains having a high atomic density and those having a low atomic density.

A is the ratio of TD to TC in the wiring layer disposed in the upper redistribution layer, and B is the ratio of TD to TC in the wiring layer disposed in the lower redistribution layer.

In one embodiment, the packaging substrate may have a value of A divided by B in the range of 0.60 to 0.75. The value of A/B may be 0.62 or more, 0.64 or more, 0.66 or more, or 0.68 or more.

A packaging substrate having an A/B value within the above range may exhibit high electrical conductivity, which may serve to reduce resistance in electron migration paths. This may effectively suppress the occurrence of signal reflection and distortion due to impedance mismatch in the packaging substrate, enabling excellent electrical signal transmission.

The value of A for the packaging substrate may be 0.2 or more. The value of A for the packaging substrate, for example, may be 0.21 or more, 0.22 or more, or 0.23 or more. The value of A may be 0.5 or less.

The value of B for the packaging substrate may be 0.5 or less. The value of B for the packaging substrate, for example, may be 0.45 or less, 0.4 or less, or 0.35 or less. The value of B may be 0.1 or more.

C is the area ratio of grains having a long-axis-to-short-axis ratio of 3:1 or greater in the wiring layer disposed in the upper redistribution layer.

D is the area ratio of grains having a long-axis-to-short-axis ratio of 3:1 or greater in the wiring layer disposed in the lower redistribution layer.

The value of C divided by D in the packaging substrate may be 0.85 to 0.99. The value of C divided by D may be 0.87 or more, 0.9 or more, or 0.92 or more. The value of C divided by D may be 0.98 or less, 0.97 or less, or 0.96 or less. A packaging substrate having the above characteristics may have a wiring layer with a grain structure suitable for electron migration paths. This may contribute to maintaining or increasing the electrical conductivity of the wiring layer and is considered to play an important role in reducing electromagnetic interference (EMI) and crosstalk phenomena, particularly during high-frequency signal transmission. A packaging substrate with these characteristics may have reduced resistance in electron migration paths, reduced signal distortion, and, as a result, improved electrical conductivity.

The average grain size in the wiring layer disposed in the upper redistribution layer may be smaller than the average grain size in the wiring layer disposed in the lower redistribution layer. In such cases, both mechanical strength and electrical performance of the packaging substrate can be improved.

The average grain size in the wiring layer disposed in the upper redistribution layer may be 0.45 µm or more and 0.48 µm or less. The average grain size, for example, may be 0.46 µm or more, or 0.465 µm or more. The average grain size may be 0.48 µm or less, 0.475 µm or less, or 0.47 µm or less.

When the average grain size falls within the above range, an excellent wiring layer suitable for the upper redistribution layer can be obtained in terms of both mechanical strength and electrical performance.

The average grain size in the wiring layer disposed in the lower redistribution layer may be 0.50 µm or more and 0.53 µm or less. The average grain size, for example, may be 0.505 µm or more, or 0.51 µm or more. The average grain size may be 0.525 µm or less, or 0.52 µm or less.

When the average grain size falls within the above range, an excellent wiring layer suitable for the lower redistribution layer can be obtained in terms of both mechanical strength and electrical performance.

The impedance of the packaging substrate may be 49 Ω or more and 52 Ω or less. The impedance may be 49.3 Ω or more, 49.6 Ω or more, or 49.8 Ω or more. The impedance may be 51.5 Ω or less, 51 Ω or less, or 50.5 Ω or less. In such cases, the packaging substrate may enable signal transmission with higher transmission efficiency.

The packaging substrate may have an electrical conductivity of 5.2 × 10⁷ S/m or more. The electrical conductivity may be 5.4 × 10⁷ S/m or more, 5.6 × 10⁷ S/m or more, or 5.7 × 10⁷ S/m or more. The electrical conductivity may be 10 × 10⁷ S/m or less.

The impedance and electrical conductivity values are based on measurements obtained using the methods described in the experimental examples below.

The packaging substrate may have a reflection coefficient of 3.2% or less. The reflection coefficient may be 3.1% or less, 3.0% or less, 2.9% or less, or 2.8% or less.

The packaging substrate may have a signal delay of 80 ps or less. The signal delay may be 78 ps or less, 76 ps or less, or 75 ps or less.

The packaging substrate according to the embodiment may exhibit excellent crystalline structure and electrical characteristics of the wiring layers, and thus is expected to provide stable and reliable performance in electronic devices requiring high-speed signal transmission.

The packaging substrate of the embodiment may reduce transmission loss and be highly applicable to fields such as 5G communications, high-speed computing, and data transmission systems that require high-speed signal transmission.

Hereinafter, the present invention will be described in more detail through specific examples. These examples are provided solely for the purpose of assisting in the understanding of the invention, and the scope of the invention is not limited thereto.

### Manufacturing Example

A glass substrate was cut into a size of 10 cm × 10 cm. To clean the substrate surface, it was etched for 5 minutes in a mixed solution of 1.8 M hydrofluoric acid (HF) and 1.0 M nitric acid (HNO₃). Immediately after etching, the substrate was rinsed with deionized water for 1 minute and 30 seconds, and then neutralized for 30 seconds using a 4.5% neutralizing solution (sodium bicarbonate). The neutralized substrate was rinsed again with deionized water and completely dried with nitrogen gas. This substrate was used as the glass core, and a redistribution layer was formed as described below.

### Example 1

### Example 1-1: Upper Redistribution Layer

On the upper surface of the glass core, a titanium (Ti) seed layer having a thickness of 50 nm was deposited by sputtering, followed by deposition of copper (Cu) to a thickness of 120 nm to form a seed layer. The electroplating solution comprised 75 g/L copper(II) sulfate, 200 g/L sulfuric acid, and 50 mg/L hydrochloric acid (HCl). As additives, 4.0 ppm polyethylene glycol (PEG), 3.0 ppm sodium sulfide (SPS), and 0.8 ppm Janus Green B (JGB) were added.

Electroplating was conducted at a temperature of 24°C, with a current density of 1.8 A/dm², for 33 minutes, thereby forming a copper wiring layer having a thickness of 9 µm. After electroplating was completed, the substrate was rinsed with deionized water and dried with nitrogen gas. The formed copper wiring layer was heat-treated in a nitrogen atmosphere at 220°C for 45 minutes to grow the crystal grains and optimize electrical conductivity.

Subsequently, to form the upper redistribution layer, a total of six copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all six upper layers were formed. After the upper redistribution layer was fully laminated, a polyimide layer was laminated to a thickness of 20 µm.

### Example 1-2: Lower Redistribution Layer

Sputtering and plating were carried out in the same manner as in Example 1-1. However, electroplating was performed at a temperature of 25°C, with a current density of 1.8 A/dm², for 28 minutes. Through this process, the copper wiring layer was formed to a thickness of 8.5 µm.

After completion of electroplating, the substrate was rinsed with deionized water and dried with nitrogen gas. The formed copper wiring layer was heat-treated in a vacuum atmosphere at 210°C for 25 minutes to grow the crystal grains and optimize electrical conductivity.

Subsequently, to form the lower redistribution layer, a total of three copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all three lower layers were formed. After the lower redistribution layer was fully laminated, a solder resist layer was laminated to a thickness of 18 µm.

### Example 2

### Example 2-1: Upper Redistribution Layer

Sputtering and plating were carried out in the same manner as in Example 1-1. However, electroplating was performed at a temperature of 24°C, with a current density of 1.95 A/dm², for 28 minutes. Through this process, the copper wiring layer was formed to a thickness of 9.2 µm.

After completion of electroplating, the substrate was rinsed with deionized water and dried with nitrogen gas. The formed copper wiring layer was heat-treated in a vacuum atmosphere at 227°C for 38 minutes to grow the crystal grains and optimize electrical conductivity.

Subsequently, to form the upper redistribution layer, a total of six copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all six upper layers were formed. After the upper redistribution layer was fully laminated, a polyimide layer was laminated to a thickness of 18 µm.

### Example 2-2: Lower Redistribution Layer

Sputtering and plating were carried out in the same manner as in Example 1-1. However, electroplating was performed at a temperature of 25°C, with a current density of 1.95 A/dm², for 29 minutes. Through this process, the copper wiring layer was formed to a thickness of 9.0 µm.

After completion of electroplating, the substrate was rinsed with deionized water and dried with nitrogen gas. The formed copper wiring layer was heat-treated in a vacuum atmosphere at 223°C for 32 minutes to grow the crystal grains and optimize electrical conductivity.

Subsequently, to form the lower redistribution layer, a total of three copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all three lower layers were formed. After the lower redistribution layer was fully laminated, a solder resist layer was laminated to a thickness of 17 µm.

### Example 3

### Example 3-1: Upper Redistribution Layer

Sputtering and plating were carried out in the same manner as in Example 1-1. However, electroplating was performed at a temperature of 23°C, with a current density of 1.85 A/dm², for 33 minutes. Through this process, the copper wiring layer was formed to a thickness of 9.3 µm.

After completion of electroplating, the substrate was rinsed with deionized water and dried with nitrogen gas. The formed copper wiring layer was heat-treated in a vacuum atmosphere at 232°C for 40 minutes to grow the crystal grains and optimize electrical conductivity.

Subsequently, to form the upper redistribution layer, a total of six copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all six upper layers were formed. After the upper redistribution layer was fully laminated, a polyimide layer was laminated to a thickness of 19 µm.

### Example 3-2: Lower Redistribution Layer

Sputtering and plating were carried out in the same manner as in Example 1-1. However, electroplating was performed at a temperature of 26°C, with a current density of 2.05 A/dm², for 27 minutes. Through this process, the copper wiring layer was formed to a thickness of 9.1 µm.

After completion of electroplating, the substrate was rinsed with deionized water and dried with nitrogen gas. The formed copper wiring layer was heat-treated in a vacuum atmosphere at 222°C for 30 minutes to grow the crystal grains and optimize electrical conductivity.

Subsequently, to form the lower redistribution layer, a total of three copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all three lower layers were formed. After the lower redistribution layer was fully laminated, a solder resist layer was laminated to a thickness of 18 µm.

### Comparative Example 1

### Comparative Example 1-1: Upper Redistribution Layer

On the upper surface of the glass core, a titanium (Ti) seed layer having a thickness of 50 nm was deposited by sputtering, followed by deposition of copper (Cu) to a thickness of 120 nm to form a seed layer. The electroplating solution comprised 75 g/L copper(II) sulfate, 200 g/L sulfuric acid, and 50 mg/L hydrochloric acid (HCl). As additives, 4.0 ppm polyethylene glycol (PEG), 3.0 ppm sodium sulfide (SPS), and 0.8 ppm Janus Green B (JGB) were added.

Electroplating was conducted at a temperature of 24°C, with a current density of 1.8 A/dm², for 33 minutes, thereby forming a copper wiring layer having a thickness of 9 µm.

After completion of electroplating, the substrate was rinsed with deionized water and dried with nitrogen gas. The formed copper wiring layer was heat-treated in a nitrogen atmosphere at 235°C for 38 minutes to grow the crystal grains and optimize electrical conductivity.

Subsequently, to form the upper redistribution layer, a total of six copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all six upper layers were formed. After the upper redistribution layer was fully laminated, a polyimide layer was laminated to a thickness of 17 µm.

### Comparative Example 1-2: Lower Redistribution Layer

Sputtering and plating were carried out in the same manner as in Comparative Example 1-1. However, electroplating was performed at a temperature of 24°C, with a current density of 2.1 A/dm², for 29 minutes. Through this process, the copper wiring layer was formed to a thickness of 8.2 µm.

After completion of electroplating, the substrate was rinsed with deionized water and dried with nitrogen gas. The formed copper wiring layer was heat-treated in a vacuum atmosphere at 240°C for 30 minutes to grow the crystal grains and optimize electrical conductivity.

Subsequently, to form the lower redistribution layer, a total of three copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all three lower layers were formed. After the lower redistribution layer was fully laminated, a solder resist layer was laminated to a thickness of 17 µm.

### Comparative Example 2

### Comparative Example 2-1: Upper Redistribution Layer

Sputtering and plating were carried out in the same manner as in Comparative Example 1-1. However, electroplating was performed at a temperature of 22°C, with a current density of 2.0 A/dm², for 34 minutes. Through this process, the copper wiring layer was formed to a thickness of 7.3 µm. After completion of electroplating, the substrate was rinsed with deionized water and dried with nitrogen gas. The formed copper wiring layer was heat-treated in a vacuum atmosphere at 225°C for 38 minutes to grow the crystal grains and optimize electrical conductivity.

Subsequently, to form the upper redistribution layer, a total of six copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all six upper layers were formed. After the upper redistribution layer was fully laminated, a polyimide layer was laminated to a thickness of 16 µm.

### Comparative Example 2-2: Lower Redistribution Layer

Sputtering and plating were carried out in the same manner as in Comparative Example 1-1. However, electroplating was performed at a temperature of 23°C, with a current density of 2.4 A/dm², for 30 minutes. Through this process, the copper wiring layer was formed to a thickness of 8.1 µm.

After completion of electroplating, the substrate was rinsed with deionized water and dried with nitrogen gas. The formed copper wiring layer was heat-treated in a vacuum atmosphere at 240°C for 32 minutes to grow the crystal grains and optimize electrical conductivity.

Subsequently, to form the lower redistribution layer, a total of three copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all three lower layers were formed. After the lower redistribution layer was fully laminated, a solder resist layer was laminated to a thickness of 17 µm.

### Comparative Example 3

### Comparative Example 3-1: Upper Redistribution Layer

Sputtering and plating were carried out in the same manner as in Comparative Example 1-1. However, electroplating was performed at a temperature of 24°C, with a current density of 1.8 A/dm², for 31 minutes. Through this process, the copper wiring layer was formed to a thickness of 8.2 µm. After completion of electroplating, the substrate was rinsed with deionized water and dried with nitrogen gas. The formed copper wiring layer was heat-treated in a vacuum atmosphere at 228°C for 40 minutes to grow the crystal grains and optimize electrical conductivity.

Subsequently, to form the upper redistribution layer, a total of six copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all six upper layers were formed. After the upper redistribution layer was fully laminated, a polyimide layer was laminated to a thickness of 18 µm.

### Comparative Example 3-2: Lower Redistribution Layer

Sputtering and plating were carried out in the same manner as in Comparative Example 1-1. However, electroplating was performed at a temperature of 25°C, with a current density of 1.9 A/dm², for 29 minutes. Through this process, the copper wiring layer was formed to a thickness of 8.4 µm.

After completion of electroplating, the substrate was rinsed with deionized water and dried with nitrogen gas. The formed copper wiring layer was heat-treated in a vacuum atmosphere at 232°C for 30 minutes to grow the crystal grains and optimize electrical conductivity.

Subsequently, to form the lower redistribution layer, a total of three copper wiring layers were stacked. Each wiring layer was formed by repeating the electroplating and heat-treatment processes, and between each layer, an epoxy film insulator (Ajinomoto Build-up Film, ABF, manufactured by Ajinomoto) was laminated to prevent electrical interference and maintain insulation properties. Through repeated lamination of the copper wiring layers and the epoxy film insulating layers, all three lower layers were formed. After the lower redistribution layer was fully laminated, a solder resist layer was laminated to a thickness of 18 µm.

The manufacturing conditions for the samples of the examples and comparative examples are summarized in Table 1 below.

**[Table 1]**

| Classific ation | Electro plating Tempera ture (°C) | Current Density (A/dm²) | Platin g Time (min) | Copper Wiring Layer Thickness (µm) | Heat-Treatment Temperatur e (°C) | Heat-Treatmen t Time (min) | Protective Layer Thickness (µm) |
|---|---|---|---|---|---|---|---|
| Example 1-1 | 24 | 1.8 | 33 | 9 | 220 | 45 | 20 |
| Example 1-2 | 25 | 1.8 | 28 | 8.5 | 210 | 25 | 18 |
| Example 2-1 | 24 | 1.95 | 28 | 9.2 | 227 | 38 | 18 |
| Example 2-2 | 25 | 1.95 | 29 | 9 | 223 | 32 | 17 |
| Example 3-1 | 23 | 1.85 | 33 | 9.3 | 232 | 40 | 19 |
| Example 3-2 | 26 | 2.05 | 27 | 9.1 | 222 | 30 | 18 |
| Compara tive Example 1-1 | 23 | 2 | 34 | 7.8 | 235 | 38 | 17 |
| Compara tive Example 1-2 | 24 | 2.1 | 29 | 8.2 | 240 | 30 | 17 |
| Compara tive Example 2-1 | 22 | 2 | 34 | 7.3 | 225 | 38 | 16 |
| Compara tive Example 2-2 | 23 | 2.4 | 30 | 8.1 | 240 | 32 | 17 |

### Measurement of Electrical Conductivity

The measurement of electrical conductivity was conducted in accordance with ASTM B193-19 standards. Using a Keithley 2450 SourceMeter, the resistance of copper thin-film samples was measured by the four-point probe method, and the electrical conductivity was calculated accordingly. The thickness of each sample was precisely measured using a scanning electron microscope (SEM) or a profilometer. Measurements were carried out at a temperature of 23 ± 1 °C. The current range was set from 0.1 mA to 100 mA, and the voltage range was set from 1 mV to 100 mV. For each sample, measurements were taken at five different locations, with three repeated measurements at each location, resulting in a total of 15 data points from which the average value and standard deviation were calculated. Additionally, the equipment was calibrated using a standard copper sample, and measurement uncertainty was evaluated to ensure reliability. Sample handling was performed with consideration to prevent contamination during the process.

### Measurement of Impedance

Impedance was measured using a Keithley 2450 SourceMeter. The four-point probe method was applied, serving as a standard technique to precisely measure the resistance and impedance of the samples. The instrument used was model 2450, manufactured by Keithley Instruments, Inc., and the impedance of the wiring layers in both the upper redistribution layer and the lower redistribution layer was measured separately. Measurements were conducted at room temperature (23°C). To obtain accurate data, each sample was measured three times, and the average value was used.

Prior to measurement, each sample was cleaned with ethanol and thoroughly dried with nitrogen gas. The impedance measurement was performed by supplying a current of 1 mA using the Keithley 2450 SourceMeter. Electrodes of the wiring layers in the upper and lower redistribution layers were connected to the four-point probe, and data were collected in precision resistance measurement mode. Impedance values were measured over a frequency range from 1 Hz to 10 MHz, and the measurement data were automatically collected using the Keithley Test Script Processor (TSP) program. Each measurement value was recorded as an average of three repeated measurements, and standard deviations were also recorded to ensure the reliability of the results.

To reduce potential noise during impedance measurement, all wiring was connected using shielded cables to minimize external interference.

The measurement results are shown in Table 2 below.

### Measurement of EBSD (Electron Backscatter Diffraction)

Sample pretreatment was performed as follows. Packaging substrate specimens were cut at random locations using a knife. The cut samples were hot-mounted using carbon paste for 15 minutes. The mounted samples were then polished so that the wiring layers (copper layers) of the upper redistribution layer and the lower redistribution layer were each exposed.

Polishing was performed as follows: SiC abrasive papers (#600, #2000, and #4000) were used with water at a rotation speed of 120 RPM for 2 hours. Thereafter, diamond suspension (DP-suspension, 3 µm and 1 µm) was used with ethanol at 120 RPM for 20 minutes. Subsequently, colloidal silica suspension (OP-suspension, 0.04 µm) was used with lubricant blue at 120 RPM for 1 hour. The polished samples were cleaned in an ultrasonic cleaner with ethanol and then dried with a dryer for 10 minutes. The dried samples were measured using SEM-EBSD at an accelerating voltage of 15 kV. The analysis area was randomly selected, with a width of 40 µm and a step size of 0.06 µm, and each measurement was conducted for 30 minutes.

The SEM equipment used was a JSM-7100F (JEOL Co.), and EBSD measurements were performed using EDAX.

The EBSD analysis software used was OIM Data Collection, and data processing was conducted using TSL OIM Analysis.

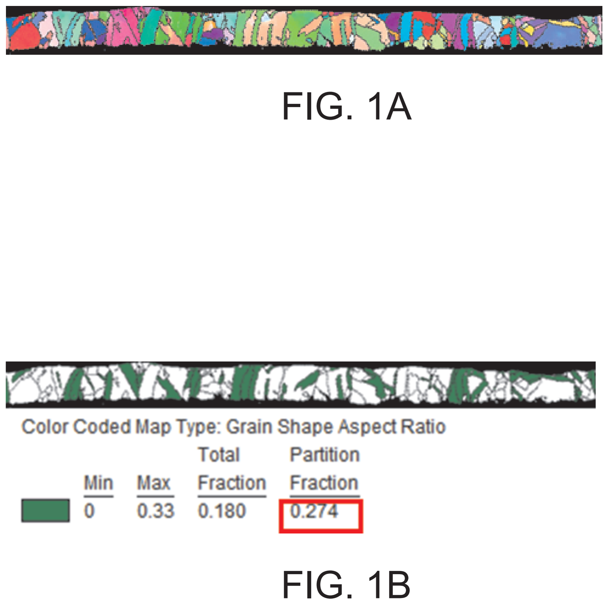

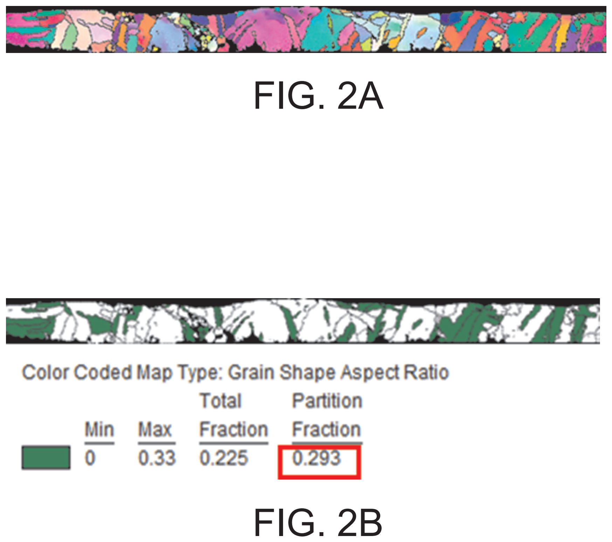

The measurement results are shown in Table 2 below. The results for Example 1-1 and Example 1-2 are respectively presented in FIGS. 1A to 1C and FIGS. 2A to 2C.

**[Table 2]**

| | A* | B* | C** | D** | A/B |
|---|---|---|---|---|---|
| Example 1 | 0.229 | 0.342 | 27.4 | 29.3 | 0.669 |
| Example 2 | 0.25 | 0.35 | 27.2 | 29.4 | 0.714 |
| Example 3 | 0.26 | 0.34 | 28.3 | 29.5 | 0.765 |
| Comp. Example 1 | 0.45 | 0.55 | 25.7 | 32.2 | 0.818 |
| Comp. Example 2 | 0.18 | 0.55 | 22.8 | 33.1 | 0.327 |
| Comp. Example 3 | 0.3 | 0.62 | 35.1 | 34.7 | 0.692 |

| | Upper Grain Avg. Size (µm) | Lower Grain Avg. Size (µm) | C/D | Electrical Conductivity (S/m) | Impedance (Ω) |
|---|---|---|---|---|---|
| Example 1 | 0.465 | 0.509 | 0.935 | 5.75 x 10⁷ | 50.5 |
| Example 2 | 0.461 | 0.512 | 0.925 | 5.72 x 10⁷ | 50.7 |
| Example 3 | 0.469 | 0.518 | 0.959 | 5.68 x 10⁷ | 50.9 |
| Comp. Example 1 | 0.445 | 0.539 | 0.797 | 4.80 x 10⁷ | 57.5 |
| Comp. Example 2 | 0.432 | 0.548 | 0.688 | 4.65 x 10⁷ | 61.2 |
| Comp. Example 3 | 0.491 | 0.534 | 1.012 | 4.55 x 10⁷ | 60.7 |

| | | | | | |
|---|---|---|---|---|---|
| * A is the ratio of TD to TC in the wiring layer disposed in the upper redistribution layer, and B is the ratio of TD to TC in the wiring layer disposed in the lower redistribution layer, where TC is the value obtained by summing the area ratio of (220)-oriented grains, the area ratio of (21 1)-oriented grains, and the area ratio of (310)-oriented grains as measured by EBSD, and TD is the value obtained by summing the area ratio of (111)-oriented grains and the area ratio of (200)-oriented grains as measured by EBSD. ** C is the area ratio, as measured by EBSD, of grains in the wiring layer disposed in the upper redistribution layer having a long-axis-to-short-axis ratio of 3:1 or greater, and D is the area ratio, as measured by EBSD, of grains in the wiring layer disposed in the lower redistribution layer having a long-axis-to-short-axis ratio of 3:1 or greater. | | | | | |

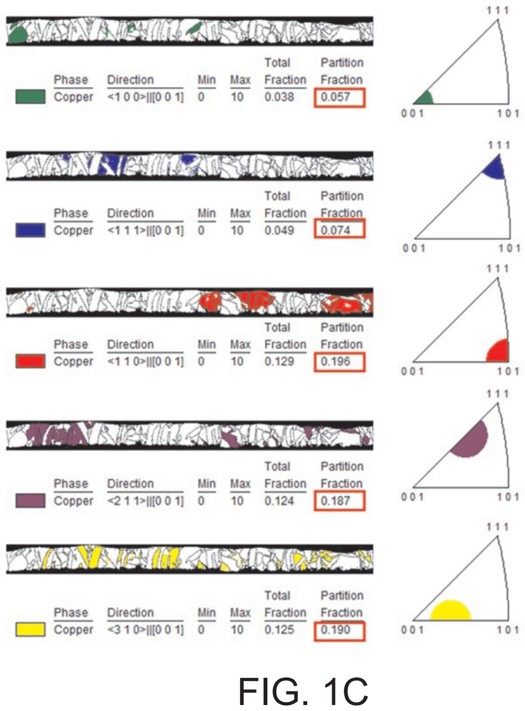

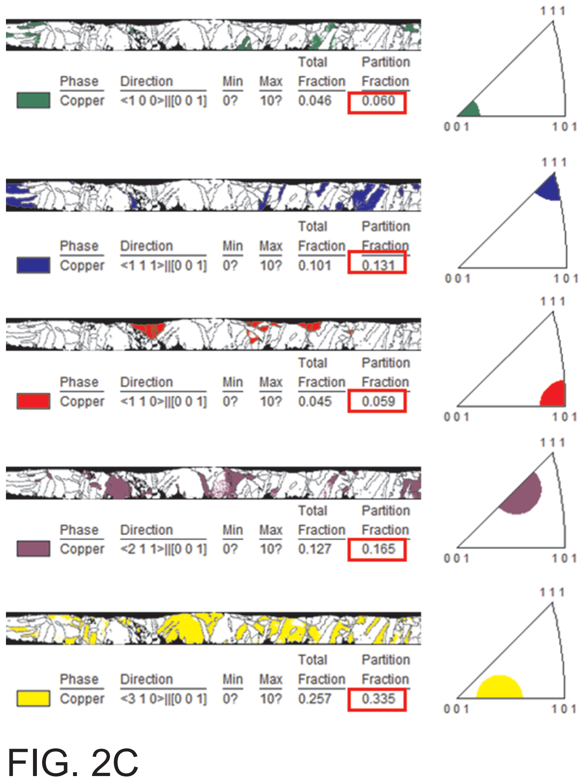

FIG. 1A is a view showing the EBSD map of Example 1-1, FIG. 1B is a view showing the area ratio of grains having a long-axis-to-short-axis ratio of 3: 1 in Example 1-1, and FIG. 1C is a view showing the area ratio of each oriented grain in Example 1-1. FIG. 2A is a view showing the EBSD map of Example 1-2, FIG. 2B is a view showing the area ratio of grains having a long-axis-to-short-axis ratio of 3:1 in Example 1-2, and FIG. 2C is a view showing the area ratio of each oriented grain in Example 1-2.

Referring to Table 1, FIGS. 1A to 1C, and FIGS. 2A to 2C, in the examples, the A/B ratio was in the range of 0.669 to 0.765. This indicates that the sum of the (111) orientation grain area ratio and the (200) orientation grain area ratio was appropriately maintained relative to the sum of the (220) orientation grain area ratio, the (211) orientation grain area ratio, and the (310) orientation grain area ratio, and demonstrates that the electrical characteristics between wiring layers were excellent. In this regard, the impedance of the examples was measured in the range of 50.5 Ω to 50.9 Ω, showing that signal loss was low and transmission efficiency was high. In addition, the electrical conductivity remained at a high level of 5.68 × 10⁷ S/m to 5.75 × 10⁷ S/m, confirming that the electrical transmission characteristics were excellent.

The C/D ratio was also in the range of 0.925 to 0.959, which is interpreted as indicating that grains having a long-axis-to-short-axis ratio of 3:1 or greater were formed in a balanced manner, contributing to minimizing electrical interference during high-frequency transmission. The average grain size was also stably maintained at 0.461 µm to 0.469 µm in the wiring layer of the upper redistribution layer and 0.509 µm to 0.518 µm in the wiring layer of the lower redistribution layer, indicating that electrical characteristics and structural stability were well maintained.

In contrast, in the comparative examples, the A/B ratio was in the range of 0.327 to 0.818, and the impedance increased to 57.5 Ω to 61.2 Ω. This is considered to be due to electrical imbalance between wiring layers. In particular, the impedance value in Comparative Example 2 was as high as 61.2 Ω, indicating that signal reflection and loss increased significantly, and that signal transmission efficiency was greatly reduced.

In addition, in the comparative examples, the C/D ratio was in the range of 0.688 to 1.012, indicating that more grains having a high long-axis-to-short-axis ratio were formed in the wiring layer of the upper redistribution layer than in the wiring layer of the lower redistribution layer. This may cause interlayer imbalance, resulting in a lack of harmony in electrical characteristics between wiring layers. The average grain size in the comparative examples was also formed in an unbalanced manner between the wiring layers of the upper and lower redistribution layers, which can cause structural instability as well as degradation in electrical performance between wiring layers. The electrical conductivity in the comparative examples was also in the range of 4.55 × 10⁷ S/m to 4.80 × 10⁷ S/m, which was lower than that in the examples. This indicates that conductivity was reduced and electron migration paths were not optimized, resulting in electrical loss.

### TDR (Time Domain Reflectometry)

Time Domain Reflectometry (TDR) analysis was conducted.

The TDR analysis referred to ASTM D5272 standards while following the IPC-TM-650 2.5.5.10 method, which is more suitable for electronic device measurements. A Tektronix DSA8300 Digital Sampling Oscilloscope with an 80E10 TDR module was used to measure the reflection coefficient and signal delay time, and a GGB Industries Model 40A-GSG-150-P probe was employed. Samples were prepared in sizes of 1 cm × 1 cm, with the copper wiring layer having a thickness of 8~12 µm on the upper side and 7~10 µm on the lower side. A pulse signal with a bandwidth of 20 GHz, an amplitude of 200 mV, and a rise time of 30 ps was applied to analyze the signal transmission characteristics of the upper and lower wiring layers.

Measurements were performed in a temperature-controlled environment of 23 ± 1°C. For each sample, five different locations were measured three times each, resulting in a total of 15 measurement values from which the average and standard deviation were calculated. Data analysis was performed using Tektronix IConnect^{®} software to generate impedance profiles and to accurately calculate the reflection coefficient and signal delay time. To ensure measurement accuracy, the system was calibrated with a 50 Ω standard load, and measurement uncertainty was also evaluated.

**[Table 3]**

| | Reflection Coefficient (%) | Signal Delay (ps) |
|---|---|---|
| Example 1 | 2.7 | 76 |
| Example 2 | 2.8 | 74 |
| Example 3 | 2.9 | 73 |
| Comparative Example 1 | 4.8 | 88 |
| Comparative Example 1 | 5.2 | 89 |
| Comparative Example 1 | 5 | 86 |

Referring to Table 3, the reflection coefficients observed in Examples 1, 2, and 3 were in a very low range of 2.7% to 2.9%, whereas the reflection coefficients in Comparative Examples 1, 2, and 3 were in the range of 4.8% to 5.2%, indicating that relatively high signal loss occurred in the comparative examples. Similarly, the signal delay times in Examples 1, 2, and 3 were short, ranging from 73 ps to 76 ps, while those in Comparative Examples 1, 2, and 3 ranged from 86 ps to 89 ps, showing relatively long signal delays. These results confirm that there is a performance difference in transmission characteristics between the examples and the comparative examples, and suggest that the examples can provide stable performance during high-speed signal transmission.

The packaging substrate of the present embodiment may reduce signal reflection and distortion caused by impedance mismatch between wiring layers, thereby improving the quality of signal transmission. In addition, by controlling the crystalline structure of copper during electrical signal transmission, the signal integrity may be improved and issues such as electromagnetic interference during high-frequency signal transmission may be reduced.

Furthermore, heat generation during electrical signal transmission may be reduced, thereby improving the efficiency of both power delivery and signal transmission, and enhancing reliability.

While the invention has been described in detail with reference to preferred embodiments, the scope of the invention is not limited thereto, and various modifications and improvements made by those skilled in the art based on the basic concept of the invention as defined in the following claims also fall within the scope of the invention.

## Claims

1. A packaging substrate comprising:
a glass core;
an upper redistribution layer; and
a lower redistribution layer,
wherein the glass core is a plate-shaped glass in which vias are disposed,
the upper redistribution layer is disposed on an upper side of the glass core,
the lower redistribution layer is disposed on a lower side of the glass core,
each of the upper redistribution layer and the lower redistribution layer comprises a wiring layer and an insulating layer,
the wiring layer is a patterned copper layer having grains,
the insulating layer is a layer comprising an insulating polymer resin or an insulating inorganic material,
an upper surface is located at an upper side of the upper redistribution layer, and an electronic device is mounted on the upper surface,
a lower surface, facing the upper surface, is located at a lower side of the lower redistribution layer,
C is an area ratio of the grains, measured in the wiring layer disposed in the upper redistribution layer, having a long-axis-to-short-axis ratio of 3:1 or greater,
D is an area ratio of the grains, measured in the wiring layer disposed in the lower redistribution layer, having a long-axis-to-short-axis ratio of 3:1 or greater, and
a value obtained by dividing C by D is 0.85 or more and 0.99 or less.

2. The packaging substrate of claim 1,
wherein the patterned copper layer comprises (111)-oriented grains, (200)-oriented grains, (220)-oriented grains, (211)-oriented grains, and (310)-oriented grains,
TC is a value obtained by summing an area ratio of the (220)-oriented grains, an area ratio of the (211)-oriented grains, and an area ratio of the (310)-oriented grains,
TD is a value obtained by summing an area ratio of the (111)-oriented grains and an area ratio of the (200)-oriented grains,
A is a ratio of TD to TC in the wiring layer disposed in the upper redistribution layer,
B is a ratio of TD to TC in the wiring layer disposed in the lower redistribution layer, and
a value obtained by dividing A by B is 0.60 or more and 0.75 or less.

3. The packaging substrate of claim 1 or claim 2,
wherein an average grain size in the wiring layer disposed in the lower redistribution layer is greater than an average grain size in the wiring layer disposed in the upper redistribution layer.

4. The packaging substrate of claim 2 or claim 3,
wherein A of the packaging substrate is 0.2 or greater.

5. The packaging substrate of any one from claim 1 to claim 4,
wherein an average grain size in the wiring layer disposed in the upper redistribution layer is 0.45 µm or more and 0.48 µm or less.

6. The packaging substrate of any one from claim 1 to claim 5,
wherein an average grain size in the wiring layer disposed in the lower redistribution layer is 0.50 µm or more and 0.53 µm or less.

7. The packaging substrate of any one from claim 1 to claim 6,
wherein the packaging substrate has an impedance of 49 Ω or more and 52 Ω or less.

8. The packaging substrate of any one from claim 1 to claim 7,
wherein the packaging substrate has an electrical conductivity of 5.0 × 10⁷ S/m or greater.

9. The packaging substrate of any one from claim 1 to claim 8,
wherein the packaging substrate has a reflection coefficient of 3.2% or less.

10. The packaging substrate of any one from claim 1 to claim 9,
wherein the packaging substrate has a signal delay of 80 ps or less.
